Europäisches Patentamt

(19) European Patent Office

Office européen des brevets

(11) Veröffentlichungsnummer: **0 162 314**

**A1**

# (12) EUROPÄISCHE PATENTANMELDUNG

(21) Anmeldenummer: **85104925.4**

(22) Anmeldetag: **23.04.85**

(51) Int. Cl.⁴: **H 03 M 1/46**
**H 03 M 1/18**

(30) Priorität: **15.05.84 CH 2378/84**

(43) Veröffentlichungstag der Anmeldung:
**27.11.85 Patentblatt 85/48**

(84) Benannte Vertragsstaaten:
**CH DE FR GB LI SE**

(71) Anmelder: **BBC Aktiengesellschaft Brown, Boveri & Cie.**
**Haselstrasse**
**CH-5401 Baden(CH)**

(72) Erfinder: **Lanz, Otto, Dr.**
**Zweierestrasse 5d**
**CH-5443 Niederrohrdorf(CH)**

(72) Erfinder: **Maschek, Martin**
**Juchstrasse 10**
**CH-8116 Würenlos(CH)**

(72) Erfinder: **Mastner, Georg, Dr.**
**Loonstrasse 5**
**CH-5443 Niederrohrdorf(CH)**

(54) **Analog-Digital-Wandler.**

(57) Einem digitalen Integrator (1) mit 16-Bit-Ausgang ist ein erster 12-Bit-Digital-Analog-Wandler (2a) nachgeschaltet, dem die Ausgangsbits 1 - 11 und 16 des Integrators (1) zugeführt werden und der mit einem ersten Subtrahierglied (3a), das aus dem zum Eingangssignal des Analog-Digital-Wandlers proportionalen Ausgangssignal eines ersten Verstärkers (4a) und dem Ausgangssignal des ersten Digital-Analog-Wandlers (2a) ein erstes Differenzsignal bildet, sowie einer Nachführschaltung (6), das aufgrund des Differenzsignals Nachführsignale für den Integrator (1) erzeugt, eine erste Nachlaufschleife bildet.

Zwecks Vergrösserung der Dynamik ist ein zweiter 12-Bit-Digital-Analog-Wandler (2b) vorhanden, dem vom Ausgang des Integrators Bits 5 - 16 zugeführt werden und der mit einem zweiten Subtrahierglied (3b) und einem zweiten Verstärker (4b), dessen Verstärkungsfaktor ein Sechzehntel des Verstärkungsfaktors des ersten Verstärkers (4a) beträgt, eine zweite Nachlaufschleife, auf welche bei Ueberschreitung des mit ersten Digital-Analog-Wandlers (2a) beherrschbaren Bereichs durch eine Steuerlogik (15) umgeschaltet wird. Die Rückumschaltung erfolgt beim nächsten Nulldurchgang, d.h. Wechsel des höchstwertigen Bits.

Der Digital-analog-Wandler eignet sich besonders zur Verarbeitung des Ausgangssignals eines Strom- oder Spannungs-wandlers.

./...

EP 0 162 314 A1

FIG.1

- 1 -


Analog-Digital-Wandler


Die Erfindung bezieht sich auf einen Analog-Digital-Wandler gemäss dem Oberbegriff des Anspruchs 1.

Es ist ein gattungsgemässer Analog-Digital-Wandler bekannt (US-PS 4 296 412), bei welchem sämtliche Bits des digitalen Ausgangssignals einem einzigen Digital-Analog-Wandler zugeführt werden, welcher ein entsprechendes Analogsignal erzeugt, das mit einem zum Eingangssignal mit einem festen Faktor proportionalen Signal verglichen wird.

Ein besonderer Vorteil eines solchen Nachlauf-Analog-Digital-Wandlers besteht im ausserordentlich schnellen "data-refresh", der unter normalen Betriebsbedingungen nur eine Taktperiode in Anspruch nimmt.

Die Auflösung eines derartigen Analog-Digital-Wandlers und damit, bei gegebenen Anforderungen an die Genauigkeit der Umsetzung des Eingangssignals, auch wenn besagte Anforderungen nur für einen Teil des von dem letzteren überstrichenen Bereichs gelten, die Dynamik, hängt vom verwendeten Digital-Analog-Wandler ab.

Aufgabe der Erfindung ist es, einen gattungsgemässen Analog-Digital-Wandler anzugeben, welcher gegenüber dem bekannten gattungsgemässen Analog-Digital-Wandler mit Digital-Analog-Wandlern gleichen Typs eine grössere Dynamik erreicht, dabei aber, solange sich das Eingangssignal innerhalb des Bereichs bewegt, in dem es auch vom bekannten gattungsgemässen Analog-Digital-Wandler verarbeitet werden könnte, dasselbe mindestens mit der gleichen Genauigkeit umsetzt wie der letztere. Die Erweiterung der Dynamik soll dabei ohne Einbusse des schnellen "data-refresh" erfolgen.

Diese Aufgabe wird durch die Erfindung, wie sie in den Ansprüchen gekennzeichnet ist, gelöst.

Die durch die Erfindung erreichbaren Vorteile sind vor allem darin zu sehen, dass bei Verwendung von Digital-Analog-Wandlern gegebener Leistungsfähigkeit gegenüber bekannten, gattungsgemässen Analog-Digital-Wandlern die Dynamik wesentlich gesteigert werden kann, ohne dass sich der Quantisierungsfehler in dem mit bekannten gattungsgemässen Analog-Digital-Wandlern beherrschbaren Bereich vergrösserte oder Einbussen in der Schnelligkeit hingenommen werden müssten.

Besonders geeignet sind erfindungsgemässe Analog-Digital-Wandler zur Umsetzung des Ausgangssignals eines Strom- oder Spannungswandlers, insbesondere eines solchen, der zugleich Mess- und Schutzzwecken dienen kann, da nicht nur das ungestörte Signal, das innerhalb eines begrenzten Bereichs bleibt, mit hohen, für Messzwecke ausreichender Genauigkeit umgesetzt werden kann, sondern auch Störungen grosser Amplitude, wie sie z.B. bei Kurzschlüssen auftreten, mindestens für Schutzzwecke hinreichend genau erfasst werden können.

Im folgenden wird die Erfindung anhand von Zeichnungen, welche nur ein Ausführungsbeispiel darstellen, und von einigen Diagrammen näher erläutert.

0162314
49/84

Es zeigen

Fig. 1 ein Blockschaltbild eines erfindungsgemässen Analog-Digital-Wandlers,

Fig. 2 ein detailliertes Schaltbild eines Teils des erfindungsgemässen Analog-Digital-Wandlers gemäss Fig. 1, und

Fig. 3 einen beispielsweisen zeitlichen Verlauf des Eingangsignals, respektive des demselben entsprechenden Ausgangssignals des erfindungsgemässen Analog-Digital-Wandlers gemäss Fig. 1 und 2 in analoger Darstellung und die zeitlichen Verläufe zweier Bits desselben sowie weitere im erfindungsgemässen Analog-Digital-Wandler auftretende Signale.

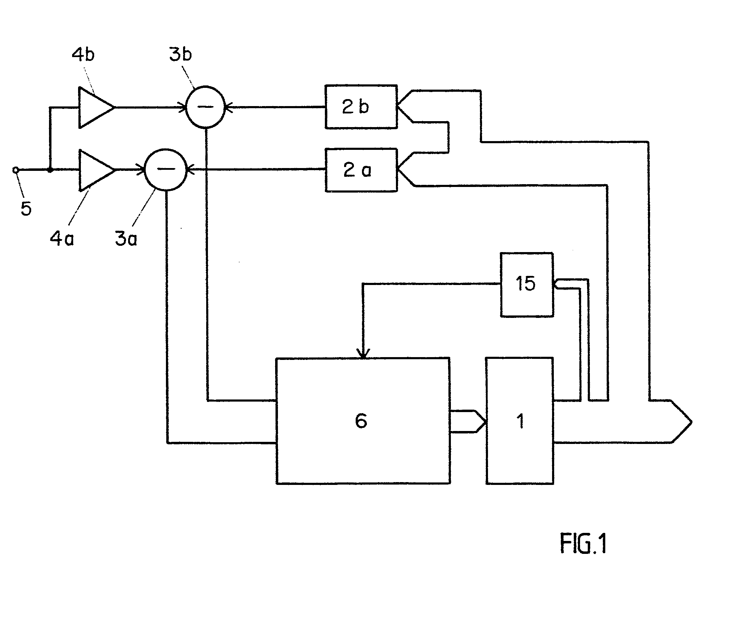

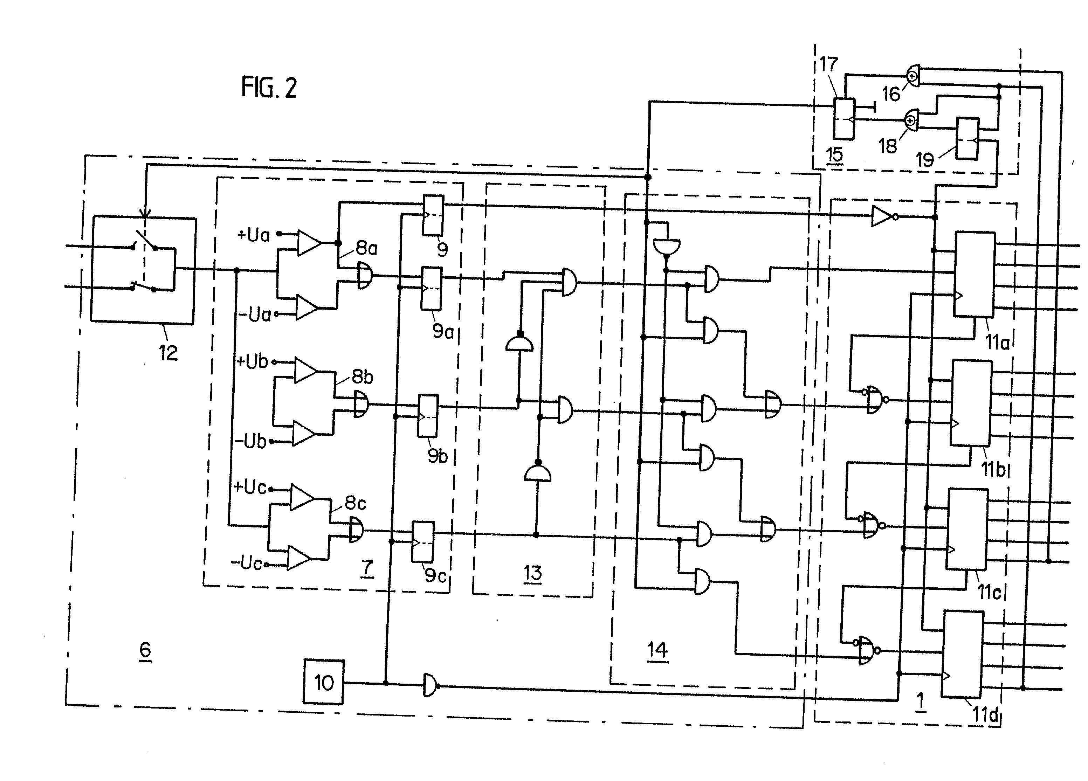

In seinem grundsätzlichen Aufbau weist der in den Figuren 1 und 2 dargestellte Analog-Digital-Wandler einen digitalen Integrator 1 mit 16-Bit-Ausgang auf, einen dem Integrator 1 nachgeschalteten ersten 12-Bit-Digital-Analog-Wandler 2a, ein erstes Subtrahierglied 3a, welches ein erstes Differenzsignal aus dem Ausgangssignal eines ersten Verstärkers 4a, dessen Eingang mit der Eingangsklemme 5 des Analog-Digital-Wandlers verbunden ist und dem Ausgangssignal des ersten Digital-Analog-Wandlers 2a bildet sowie eine dem Integrator 1 vorgeschaltete Nachführschaltung 6, der besagtes erstes Differenzsignal zugeführt wird. Die Nachführschaltung enthält einen Differenzdiskriminator 7 mit einem ersten Diskriminator 8a, welcher feststellt, ob das am Eingang des Differenzdiskriminators 7 liegende Signal zwischen einem ersten unteren Grenzwert $-U_a$ und einem ersten oberen Grenzwert $+U_a$ liegt und wenn nicht, ob es positiv oder negativ ist. Der Absolutwert $U_a$ der Grenzwerte liegt dabei etwas oberhalb der Hälfte der einem niedrigstwertigen Bit entsprechenden Spannung. Zur Zwischenspeicherung der beiden Informationen sind dem ersten Diskriminator 8a zwei D-Flipflops 9, 9a nachgeschaltet, die, wie auch der Integrator 1, von einem Taktgenerator 10 gesteuert werden.

Erfindungsgemäss ist dem Integrator 1 ein zweiter 12-Bit-Digital-Analog-Wandler 2b nachgeschaltet und ein zweites Subtrahierglied 3b vorhanden, das aus dem Ausgangssignal eines zweiten mit der Eingangsklemme 5 verbundenen Verstärkers 4b, dessen Verstärkungsfaktor ein Sechzehntel des Verstärkungsfaktors des ersten Verstärkers 4a beträgt, und dem Ausgangssignal des zweiten Digital-Analog-Wandlers 2b ein zweites Differenzsignal bildet, das ebenfalls der Nachführschaltung 6 zugeführt wird. Der digitale Integrator 1 ist als vierstufige Kaskade von 4-Bit-Vorwärts-Rückwärts-Zählern 11a, b, c, d ausgebildet. Dem ersten Digital-Analog-Wandler 2a werden jeweils die elf Bits mit Wertigkeiten $2^0$ bis $2^{10}$ als Betragsbits sowie das polaritätsbestimmende höchstwertige sechzehnte Bit zugeführt, dem zweiten Digital-Analog-Wandler 2b die Bits mit Wertigkeiten $2^4$ bis $2^{14}$ als Betragsbits und ebenfalls das höchstwertige sechzehnte.

Als digitaler Integrator kann auch ein rückgekoppelter Addierer nach dem Stand der Technik benutzt werden.

Die Nachführschaltung 6 weist einen Eingangswahlschalter 12 auf, welcher wahlweise das erste oder das zweite Differenzsignal an den Eingang des Differenzdiskriminators 7 legen kann.

Der Differenzdiskriminator 7 weist noch zwei weitere als Fensterdiskriminatoren ausgebildete Diskriminatoren 8b, 8c auf, welche jeweils feststellen, ob das an seinen Eingang gelegte Differenzsignal zwischen einem zweiten unteren Grenzwert $-U_b$ und einem zweiten oberen Grenzwert $+U_b$ bzw. zwischen einem dritten unteren Grenzwert $-U_c$ und einem dritten oberen Grenzwert $+U_c$ liegt. Die Absolutwerte $U_b$,

$U_c$ der zweiten und dritten Grenzwerte können z.B. das 10-fache und das 150-fache der einem niedrigstwertigen Bit entsprechenden Spannung betragen, d.h. etwas mehr als die Hälfte der einem Bit der Wertigkeit $2^4$ bzw. $2^8$ entsprechenden Spannungen. Den Diskriminatoren 8b, c sind ebenfalls zur Zwischenspeicherung ihrer Ausgangssignale vom Taktgenerator 10 gesteuerte D-Flipflops 9b, c nachgeschaltet.

Dem Differenzdiskriminator 7 nachgeschaltet ist eine Logikschaltung 13, welche von den Ausgangssignalen der Flipflops 9a, 9b und 9c nur das Signal mit der höchsten Priorität an den Integrator weiterleitet und alle Signale niedrigerer Priorität sperrt, wobei 9c die höchste und 9a die niedrigste Priorität hat.

Am Ausgang der Nachführschaltung 6 liegt ein Ausgangswahlschalter 14, welcher Ausgangssignale der Logikschaltung 13 jeweils wahlweise an den Zähleingang eines von zwei aufeinanderfolgenden 4 Bit-Vorwärts-Rückwärts-Zählern des Integrators 1 legen kann. Der Eingangswahlschalter 12 und der Ausgangswahlschalter 14 werden gemeinsam von einer Steuerlogik 15 in Abhängigkeit von den Ausgangssignalen des Integrators 1 gesteuert. Die Steuerlogik 15 enthält ein erstes EXOR-Gatter 16, an dessen Eingang das sechzehnte und das zwölfte Bit liegen und dessen Ausgang mit dem invertierenden Setzeingang eines ersten D-Flipflops 17 (z.B. SN 74 LS 74) verbunden ist, an dessen Takteingang das Ausgangssignal eines zweiten EXOR-Gatters 18, dem das polaritätsbestimmende sechzehnte Bit einmal unmittelbar und einmal durch ein zweites D-Flipflop 19 um eine Taktperiode verzögert zugeleitet wird, gelangt und dessen D-Eingang auf Masse liegt.

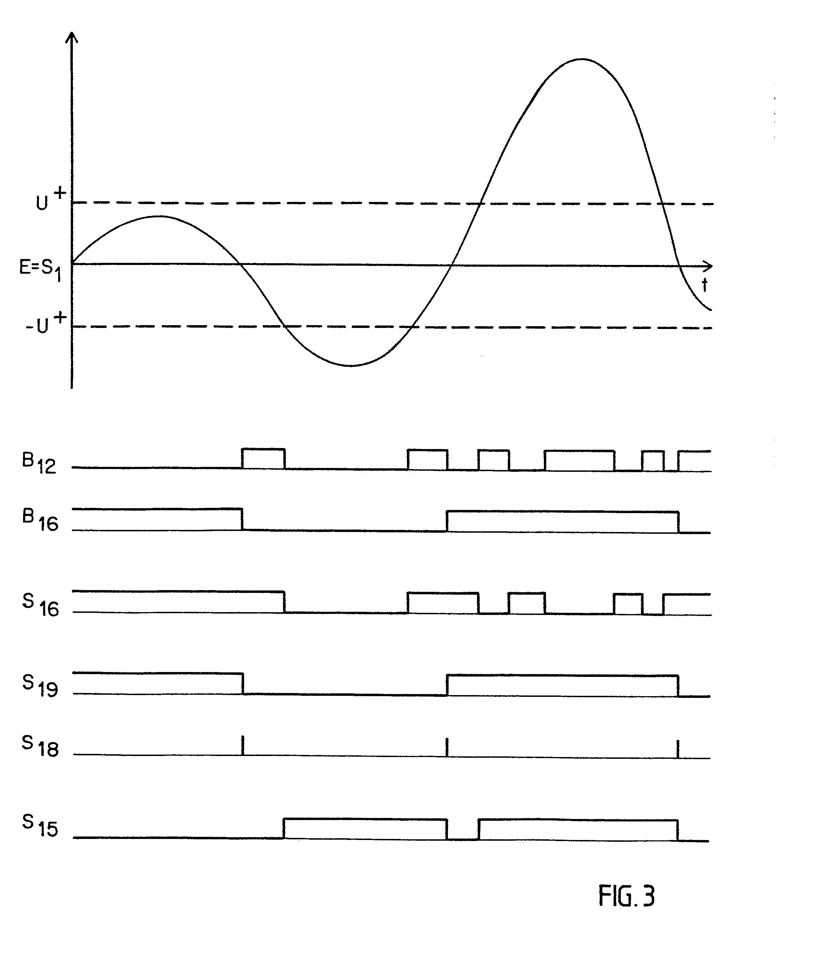

Im folgenden soll, teilweise unter Beiziehung von Fig. 3, die Funktion des Analog-Digital-Wandlers gemäss Fig. 1 und Fig. 2 näher erläutert werden.

Solange der Betrag des Eingangssignals nicht sehr gross ist, so dass - analog "0" entspricht einer Binärzahl am Ausgang des Integrators 1, bei der das höchstwertige sechzehnte Bit "1" ist und die übrigen Bits "0" sind - entweder, bei positivem Eingangssignal, das sechzehnte Bit "1" ist und die Bits vom zwölften bis zum fünfzehnten "0" sind oder, bei negativem Eingangssignal, das Umgekehrte der Fall ist - in jedem Fall aber die Bits vom zwölften bis zum fünfzehnten sich vom sechzehnten unterscheiden, ist das Ausgangssignal $S_{15}$ der Steuerlogik 15 "0". Der Eingangswahlschalter 12 legt dann das erste Differenzsignal, das aus dem Ausgangssignal des ersten Verstärkers 4a und dem des ersten Digital-Analog-Wandlers 2a gebildet wird, an den Eingang des Differenzdiskriminators 7. Sobald das Differenzsignal den ersten oberen Grenzwert $U_a$ über- oder den ersten unteren Grenzwert $-U_a$ unterschreitet, spricht der erste Diskriminator 8a an und erzeugt ein Zählsignal, das bei der nächsten positiven Flanke des Taktsignals im Flipflop 9a gespeichert und, zusammen mit dem im Flipflop 9 gespeicherten Polaritätssignal, als Nachführsignal über die Logikschaltung 13 und den Ausgangswahlschalter 14 als Vorwärts- bzw. Rückwärtszählsignal an den ersten 4-Bit-Vorwärts-Rückwärtszähler des Integrators 1 gelangt und bei der nächsten negativen Taktflanke bewirkt, dass zu der am Ausgang desselben liegenden Binärzahl ein niedrigstwertiges Bit addiert bzw. von derselben subtrahiert wird. Bei rascher Aenderung des Eingangssignals kann das Differenzsignal so gross werden, dass es den zweiten oberen Grenzwert $U_b$ über- oder den zweiten unteren Grenzwert $-U_b$ unterschreitet. In diesem Fall spricht der zweite Diskriminator 8b an und löst ein Zählsignal aus, das direkt an den Zähleingang des zweiten 4-Bit-Vorwärts-Rückwärts-Zählers 11b gelangt und die Addition bzw. Subtraktion eines Bit mit Wertigkeit $2^4$, entsprechend dem 16-fachen eines niedrigstwertigen Bit, bewirkt. Ein gleichzeitig vom ersten Diskriminator 8a ausgelöstes Zählsignal wird dabei von der Logikschaltung 13 unterdrückt. Entsprechend wird bei Ansprechen des dritten Diskriminators 8c ein Zählsignal an den Zähleingang des dritten 4-Bit-Vorwärts-Rückwärts-Zählers 11c geleitet und die Addition eines Bits mit Wertigkeit $2^8$, entsprechend dem 256-fachen eines niedrigstwertigen Bit, addiert oder subtrahiert. Auf diese Weise ist es möglich, auch bei sehr raschen Aenderungen des Eingangssignals dasselbe zwar mit grösserem Fehler als bei langsamen Aenderungen aber qualitativ richtig wiederzugeben, was bei der bereits angesprochenen Verwendung des Analog-Digital-Wandlers zur Verarbeitung des Ausgangssignals eines Strom- oder Spannungswandlers die für Schutzzwecke wichtige und auch ausreichende qualitativ richtige Widergabe von transienten Störungen erlaubt.

Dem zweiten Digital-Analog-Wandler 2b werden jeweils vom Ausgang des Integrators 1 die Bits vom fünften bis zum sechzehnten zugeführt. Diese bilden eine Binärzahl, welche der durch sämtliche Bits am Ausgang des Integrators gebildeten Binärzahl dividiert durch sechzehn entspricht, wobei der Rest - die durch die vier niedrigstwertigen Bits gebildete Binärzahl, wegfällt. Da das Ausgangssignal des ersten Verstärkers 4a und das des ersten Digital-Analog-Wandlers 2a ständig abgeglichen werden, werden somit das Ausgangssignal des zweiten Verstärkers 4b, das ja jeweils ein Sechzehntel des Ausgangssignals des ersten Verstärkers 4a beträgt und das Ausgangssignal des zweiten Digital-Analog-Wandlers 2b ständig mitabgeglichen.

Erreicht nun der Betrag des Eingangssignals eine obere Umschaltgrenze $U^+$, bei der das zwölfte Bit $B_{12}$ des nachge-führten Ausgangssignals des Integrators 1 einen Wert annimmt, der demjenigen des sechzehnten Bit $B_{16}$ gleich ist, sinkt also etwa das Ausgangssignal $S_1$ - in Fig. 3 in analoger Form dargestellt - unter $-U^+$, so dass das zwölfte Bit $B_{12}$ am Ausgang des Integrators 1 den Wert "0" annimmt, so ist der mit dem ersten Digital-Analog-Wandler 2a beherrschbare Bereich überschritten. Das Ausgangssignal $S_{16}$ des ersten EXOR-Gatters 16 wechselt auf "0" und bewirkt, an den invertierenden Setzeingang des setzbaren ersten D-Flipflops 17 geleitet, dass dessen Ausgangssignal, das zugleich das Ausgangssignal $S_{15}$ der Steuerlogik 15 ist, auf "1" gesetzt wird. Der Eingangswahlschalter 12 legt das zweite Differenzsignal an den Eingang des Differenzdiskriminators 7. Zugleich wird auch der Ausgangswahlschalter 14 umgestellt, so dass die vom ersten Diskriminator 8a ausgehenden Zählsignale nun an den Zähleingang des zweiten 4-Bit-Vorwärts-Rückwärts-Zählers 11b gelangen und auch die der anderen Diskriminatoren 8b, c an die jeweils nächsthöheren 4-Bit-Vorwärts-Rückwärts-Zähler 11c bzw. 11d umgeleitet werden, was auf eine Vergrösserung der Nachführschritte um das 16-fache hinausläuft, welche die durch die Nichtberücksichtigung der ersten vier Bits durch den zweiten Digital-Analog-Wandler 2b bewirkte Division der Ausgangszahl des Integrators 1 und die entsprechende Verkleinerung des Analogsignals, mit dem die dividierte Ausgangszahl verglichen wird, kompensiert.

Die beschriebene Umschaltung geschieht innerhalb einer Taktperiode ohne zusätzlichen Zeitverlust. Sie führt zwar zu einer Vergrösserung des Quantisierungsfehlers um das 16-fache, hat aber ebenfalls zur Folge, dass einem rasch schwankenden Eingangssignal mit 16 Mal grösseren Nachführschritten gefolgt werden kann. Da es bei vielen Anwendungen vor allem auf die relative Genauigkeit der Wiedergabe des Eingangssignals ankommt, ist das erste kaum nachteilig; da andererseits oft die auftretenden Aenderungsgeschwindigkeiten des Eingangssignals den jeweils auftretenden maximalen Signalgrössen entsprechen, ist das zweite unter Umständen sehr vorteilhaft.

Beim nächsten Nulldurchgang wechselt der Wert des polaritätsbestimmenden sechzehnten Bit. Da das Ausgangssignal $S_{19}$ des zweiten D-Flipflops 19 demselben um eine Taktperiode verzögert folgt, wechselt das Ausgangssignal $S_{18}$ des zweiten EXOR-Gatters 18 auf "1" und behält diesen Wert für die Dauer einer Taktperiode bei. Seine positive Flanke bewirkt, dass das Ausgangssignal des ersten D-Flipflops 17, dessen D-Eingang auf Masse liegt, d.h. das Ausgangssignal $S_{15}$ der Steuerlogik 15 auf "0" gesetzt wird. Null wirkt also als untere Umschaltgrenze.

Der Eingangswahlschalter 12 und der Ausgangswahlschalter 14 werden wieder umgestellt, dem Differenzdiskriminator 7 wird wiederum das Ausgangssignal des ersten Subtrahierglieds 3a zugeführt. Da dem ersten Digital-Analog-Wandler 2a die niedrigstwertigen elf Bits sowie das höchstwertige sechzehnte die ganze Zeit über zugeführt wurden und das digitale Ausgangssignal bezüglich der Bits, welche höherwertig sind als das vierte, dem Eingangssignal nachgeführt wurde, ist der erste Digital-Analog-Wandler 2a vorabgeglichen, d.h. die Differenz zwischen dem Ausgangssignal des ersten Verstärkers 4a und demjenigen des ersten Digital-Aanalog-Wandlers 2a, wie sie am Ausgang des ersten Subtrahierglieds 3a erscheint, hat bei der Umschaltung normalerweise höchstens die Grössenordnung der einem Bit der Wertigkeit $2^4$ entsprechenden Spannung.

Es liegt auf der Hand, dass der beschriebene Analog-Digital-Wandler ohne weiteres auf mehr als zwei Umschaltstufen erweitert und seine Dynamik entsprechend weiter erhöht werden kann.

Patentansprüche

1. Analog-Digital-Wandler mit einem digitalen Integrator (1), einem ersten Digital-Analog-Wandler (2a), dem vom Ausgang des digitalen Integrators (1) jeweils zugleich mit einem Polaritätsbit ($B_{16}$) eine Gruppe von bezüglich ihrer Stellenwerte unmittelbar aufeinanderfolgender Betragsbits, welche das niedrigstwertige Betragsbit einschliesst, zugeführt wird, einem ersten Subtrahierglied (3a), welches die Differenz zwischen einem dem Eingangssignal des Analog-Digital-Wandlers proportionalen Signal und dem Ausgangssignal des ersten Digital-Analog-Wandlers (2a) bildet und einer Nachführschaltung (6), der das Ausgangssignal des ersten Subtrahierglieds (3a) zugeführt wird und die Nachführsignale für den digitalen Integrator (1) erzeugt, und zwar mindestens so lange vom Ausgangssignal des ersten Subtrahierglieds (3a) gesteuert, als die von der Gruppe der dem ersten Digital-Analog-Wandler (2a) zugeführten Betragsbits gebildete Zahl unterhalb einer oberen Umschaltgrenze ($U^+$) liegt, dadurch gekennzeichnet, dass der Analog-Digital-Wandler

- mindestens einen weiteren Digital-Analog-Wandler (2b) enthält, dem vom Ausgang des Integrators (1) jeweils zugleich mit dem Polaritätsbit eine Gruppe von bezüglich ihrer Stellenwerte unmittelbar aufeinanderfolgenden Betragsbits zugeführt wird,

- zu jedem weiteren Digital-Analog-Wandler ein weiteres Subtrahierglied (3b) enthält, das die Differenz zwischen einem dem Eingangssignal des Analog-Digital-Wandlers proportionalen Signal und dem Ausgangssignal des weiteren Digital-Analog-Wandlers (2b) bildet, wobei

- die untere Grenze und die obere Grenze der Stellenwerte der einem weiteren Digital-Analog-Wandler (2b) zugeführten Betragsbits jeweils grösser ist als die untere Grenze bzw. die obere Grenze der Stellenwerte der dem voraufgehenden Digital-Analog-Wandler (2a) zugeführten Betragsbits,

- die untere Grenze der Stellenwerte der einem weiteren Digital-Analog-Wandler (2b) zugeführten Betragsbits jeweils unterhalb der oberen Grenze der Stellenwerte der dem voraufgehenden Digital-Analog-Wandler (2a) zugeführten Betragsbits liegt,

- das einem weiteren Subtrahierglied (3b) zugeführte dem Eingangssignal des Analog-Digital-Wandlers proportionale Signal sich vom dem ersten Subtrahierglied (3a) zugeführten dem Eingangssignal proportionalen Signal um einen Skalierungsfaktor $2^{-n+1}$ unterscheidet, wobei n jeweils gleich der unteren Grenze der Stellenwerte der dem entsprechenden weiteren Digital-Analog-Wandler (2b) zugeführten Betragsbits ist, dass ferner eine Steuerlogik (15) vorhanden ist, welche die Nachführschaltung (6) in Abhängigkeit vom Ausgangssignal des digitalen Integrators (1) derart steuert, dass

- wenn der Betrag der von der Gruppe der einem der Digital-Analog-Wandler (2a) zugeführten Bits dargestellten Zahl eine obere Umschaltgrenze ($U^+$) erreicht, als nächstes gegebenenfalls ein aufgrund des Ausgangssignals des jeweils weiteren Subtrahiergliedes (3b) erzeugtes Nachführsignal an den Integrator (1) gelangt,

- wenn der Betrag der von der Gruppe der einem der weiteren Digital-Analog-Wandler (2b) zugeführten Bits dargestellten Zahl eine untere Umschaltgrenze erreicht, als nächstes ein aufgrund des Ausgangssignals des jeweils voraufgehenden Subtrahierglieds (3a) erzeugtes Nachführsignal an den Integrator (1) gelangt, wobei

sich ein aufgrund des Ausgangssignals eines der weiteren Subtrahierglieder (3b) veranlasster Nachführschritt um das Inverse des jeweiligen Skalierungsfaktors, d.h.

um $2^{n-1}$, von einem aufgrund eines gleich grossen Ausgangssignals des ersten Subtrahierglieds (3a) veranlassten Nachführschritt unterscheidet.

2. Analog-Digital-Wandler nach Anspruch 1, dessen Nachführschaltung einen Differenzdiskriminator (7) enthält, dem jeweils eines der Ausgangssignale der Subtrahierglieder (3a, 3b) zugeführt wird und der

- einen ersten Diskriminator (8a) enthält, der das dem Differenzdiskriminator (7) zugeführte Signal mit einem positiven ersten oberen Grenzwert ($U_a$) und einem negativen ersten unteren Grenzwert ($-U_a$) vergleicht und

- bei Ueberschreiten des ersten oberen Grenzwerts ($U_a$) und bei Unterschreiten des ersten unteren Grenzwerts ($-U_a$) jeweils ein entsprechendes Nachführsignal zur Erhöhung bzw. Erniedrigung der am Ausgang des digitalen Integrators (1) liegenden Zahl erzeugt, dadurch gekennzeichnet, dass der Differenzdiskriminator (4)

- mindestens einen weiteren Diskriminator (8b, 8c) enthält, welcher das dem Differenzdiskriminator (7) zugeführte Signal mit einem weiteren oberen Grenzwert ($U_b$; $U_c$) und mit einem weiteren unteren Grenzwert ($-U_b$; $-U_c$) vergleicht, und

- bei Ueberschreiten des weiteren oberen Grenzwerts ($U_b$; $U_c$) und bei Unterschreiten des weiteren unteren Grenzwerts ($-U_b$; $-U_c$) jeweils ein entsprechendes Nachführsignal zur Erhöhung bzw. Erniedrigung der am Ausgang des digitalen Integrators (1) liegenden Zahl erzeugt,

wobei

- ein weiterer oberer Grenzwert und ein weiterer unterer Grenzwert jeweils dem Absolutwert nach grösser sind als der voraufgehende obere Grenzwert bzw. der voraufgehende untere Grenzwert,

0162314
49/84

- die Zahl, um die aufgrund des Ansprechens eines weiteren Diskriminators (8b; 8c) die am Ausgang des digitalen Integrators (1) liegende Zahl erhöht oder erniedrigt wird, jeweils dem Absolutwert nach grösser ist als die aufgrund des Ansprechens des voraufgehenden Diskriminators (8a; 8b) addierte oder subtrahierte Zahl.

- 1/3 -

FIG.1

FIG. 2

- 2/3 -

0162314

FIG. 3

**Europäisches Patentamt**

**EUROPÄISCHER RECHERCHENBERICHT**

**0162314**
Nummer der Anmeldung

EP 85 10 4925

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | FR-A-2 443 174 (BROWN, BOVERI & CIE) * Seite 6, Zeilen 6-37; Figur 1 * | 1 | H 03 M 1/46<br>H 03 M 1/18 |
| A | US-A-3 866 131 (FIGUEROA) * Figur 1; Spalte 2, Zeilen 40-57 * | 1 | |

| | | | RECHERCHIERTE SACHGEBIETE (Int. Cl.4) |
|---|---|---|---|
| | | | H 03 M |

Der vorliegende Recherchenbericht wurde für alle Patentansprüche erstellt.

| Recherchenort | Abschlußdatum der Recherche | Prüfer |
|---|---|---|
| DEN HAAG | 23-07-1985 | BEINDORFF W.H. |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82